# EUROPEAN PATENT APPLICATION

(11) **EP 1 830 471 A1**
(43) Date of publication of application: **05.09.2007**
(21) Application number: 06101540.0
(22) Date of filing: 10.02.2006
(51) Int. Cl.: H03M 13/15, G11B 20/18

(54) **Apparatus and method for decoding data**

(71) Applicant: DEUTSCHE THOMSON-BRANDT GMBH, 78048 Villingen-Schwenningen (DE)
(72) Inventor: Kravtchenko, Alexander, Dr., 78056 VS-Schwenningen (DE); Mueller, Stefan, 78048 VS-Villingen (DE); Kabutz, Marten, 78048 VS-Villingen (DE)
(74) Representative: Thies, Stephan

(57) **Abstract**

In an apparatus for Cross Interleave Reed-Solomon Code or CIRC decoding of data, the speed of CIRC decoding is further increased and hardware expense is reduced by having a single Reed-Solomon Decoder (14), a multiplexer (13) for selecting one of a first and a second input data as input for the Reed-Solomon Decoder (14), and a demultiplexer (15) for distributing an output of the Reed-Solomon Decoder (14) to either a first or a second correction block (17, 18). In a corresponding method for error correction decoding data, a first and a second RS decoding process (E, F) are together performed in a single RS Decoder (14) consisting of one KeySolver (19) for performing a first part of the RS decoding process (E, F) and one ChienSolver (20) for performing a second part of the RS decoding process (E, F); and the second RS decoding process (F) is started in the KeySolver (19) after the KeySolver (19) has finished the first part of the first RS decoding process (E) and before the ChienSolver (20) has finished the second part of the first RS decoding process (E).

## Description

### Field of the invention

The present invention relates to decoding of error correction coded data, in particular to the decoding of Cross-Interleaved Reed-Solomon Codes or CIRC codes.

### Background of the invention

Several methods of CIRC decoding are known. WO 02/069505 shows a conventional CIRC decoder using a RAM divided into three parts: An "M1" part is used for the one symbol delay operation, an "M2" part is used for deinterleaving, and an "M3" part is used for two symbols delay operation. In this decoder, a total of 300 memory read/write cycles are needed for processing each CIRC correction code. EP 1 388 946 shows another CIRC decoder, where with separate controlling, addressing four separate memories, and using two RS decoders, the CIRC decoding speed is increased. There, the number of read/write accesses are the same, but due to some parallel processing the decoding speed is higher: a total of only 204 memory access cycles are needed.

### Invention

After analysis, the prior art CIRC decoding methods may be seen to have the following disadvantages: The number of read/write cycles in the working memories or in one RAM is very high, which limits the decoding speed. Also, two RS decoders are needed to achieve the decoding speed.

According to the invention, using parallel-pipelined control operations and reducing the access frequency in the 3 separate working memories, the speed of CIRC decoding is further increased and only a single RS decoder is needed.

According to the invention, an apparatus for Cross Interleave Reed-Solomon Code or CIRC decoding of data has a first and a second syndrome generator for calculating a C1 respectively C2 syndrome, has a first and a second input formatter connected to an output of the first respectively second syndrome generator for converting the C1 respectively C2 syndrome into first respectively second input data, and has a first and a second correction block for correcting erroneous bytes of C1 respectively C2 codewords. Specifically, the apparatus has just a single Reed-Solomon Decoder, has a multiplexer for selecting one of the first and the second input data as input for the Reed-Solomon Decoder, and has a demultiplexer for distributing an output of the Reed-Solomon Decoder to either the first or the second correction block. This advantageously exploits the fact that within the Reed-Solomon Decoder, not all the subunits are active all the time, so that consecutive data frames can be handled in pipeline mode.

Advantageously, in the apparatus according to the invention, the Reed-Solomon Decoder comprises a KeySolver subunit and a ChienSolver subunit both independently equipped to wait for a request from a demander, to start their respective operation upon such request, to possibly request some activity from a subsequent module, and to return to the idle state after their respective operation is finished. In this way, a pipeline structure is achieved, where every block can work in parallel with the other and the performance is limited by the speed of the slowest block.

In a method for Cross Interleave Reed-Solomon Code or CIRC decoding of data according to the invention, first and second syndrome sets are generated in a first and second syndrome generator, respectively; a first and a second RS decoding request are generated after the first and second syndrome set has been calculated, respectively. Specifically, in the method, a first and a second RS decoding process are together performed in a single RS Decoder consisting of one KeySolver subunit for performing a first part of the RS decoding process and one ChienSolver subunit for performing a second part of the RS decoding process; and the second RS decoding process is started in the KeySolver subunit after the KeySolver subunit has finished the first part of the first RS decoding process, but before the ChienSolver subunit has finished the second part of the first RS decoding process.

Advantageously, in the method according to the invention, a first erroneous byte correction is started after the first RS decoding process has been finished but before the second RS decoding process has been finished.

### Drawings

Exemplary embodiments of the invention are illustrated in the drawings and are explained in more detail in the following description.

In the figures:
- Fig. 1: shows the sequence of steps for prior art CIRC decoding;
- Fig. 2: shows the block diagram of a CIRC decoder according to the invention;
- Fig. 3: shows the main data flow of the CIRC decoder according to the invention;
- Fig. 4: shows a flowchart of the sequence of operations in the input logic;
- Fig. 5: shows a timing diagram explaining the Data flow in the input buffer;
- Fig. 6: shows a flowchart of the sequence of operations in the M1 Control unit;
- Fig. 7: shows a flowchart of the sequence of operations in the M1 memory;
- Fig. 8: shows a flowchart of the sequence of operations in the M2 control unit;
- Fig. 9: shows a flowchart of the sequence of operations related to the M2 memory;
- Fig. 10: shows a first timing diagram to explain the functionality of the Status Memory;
- Fig. 11: shows a second timing diagram to explain the functionality of the Status Memory;
- Fig. 12a: shows a first part of a flowchart describing the sequence of operations in the M3 control unit;
- Fig. 12b: shows a second part of the flowchart describing the sequence of operations in the M3 control unit;
- Fig. 13: shows a flowchart describing the sequence of operations related to the M3 memory;
- Fig. 14: shows a flowchart describing the sequence of control operations related to the Status Memory;
- Fig. 15: shows a flowchart describing the sequence of control operations related to the Correct_C1 Correction block;
- Fig. 16: shows a flowchart describing the sequence of control operations related to the Correct_C2 Correction block.

### Exemplary embodiments

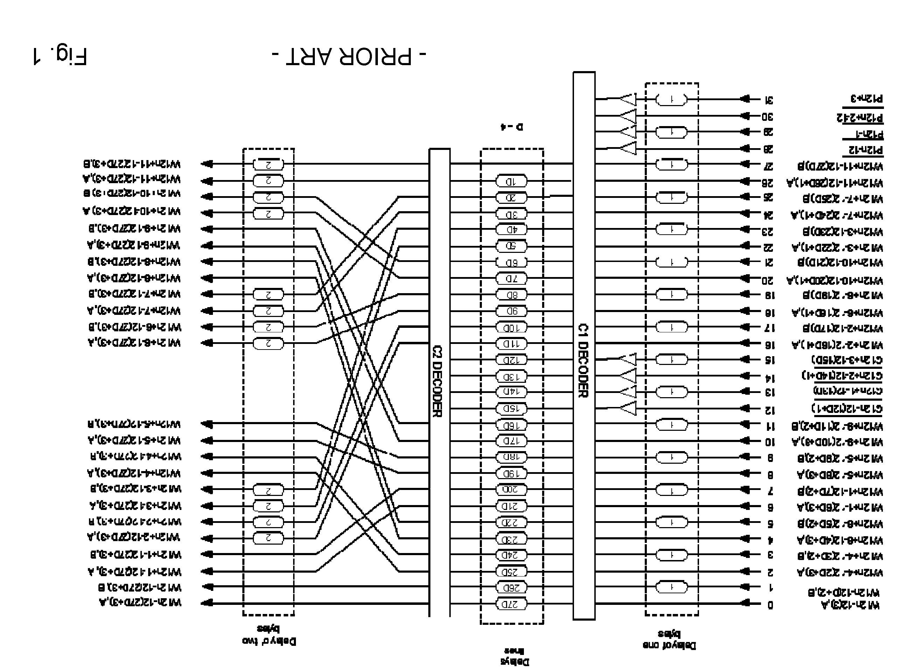

Fig. 1 shows the sequence of steps for prior art CIRC decoding as used in CD-DA, see "Compact disc digital audio, System Description", February 1985, Sony & Philips, page 34. In audio applications each audio sample is 16 bits, which is formed in two symbols of 8 bits each. Thus each 8-bit symbol is either the upper or lower side of an audio sample of one of the two channels of stereophonic audio data.

CIRC is an acronym for Cross Interleave Reed-Solomon code. In case of the CIRC correction code used in CD-DA, the encoding process of the (28,24) Reed-Solomon code, the so-called C2 code, is performed first. It inputs twenty-four data symbols each consisting of 8 bits and converts them into 28 output symbols. These data symbols are then interleaved from a first arrangement into a second arrangement. The encoding process of the (32,28) Reed-Solomon code, the so-called C1 code, is then executed, inputting 28 symbols from the second arrangement and outputting 32 symbols. Correspondingly, the main controlling tasks of the CIRC decoder are: 1) Delaying of some data; 2) C1 Decoding the (32,28) code and correcting erroneous symbols; 3) Deinterleaving; 4) C2 Decoding the (28,24) code and correcting erroneous symbols; 5) Delaying of some data.

32 symbols of incoming data form one frame and are supplied to the time delay circuit, in which only the even numbered symbols are delayed by an amount of one frame. 32 symbols output from the time delay circuit are supplied to a C1 decoder, in which the actual decoding of the (32,28) Reed-Solomon code is executed. In the C1 decoder, up to two erroneous symbols in a C1 code word are being corrected, but when three or more errors are detected, the erasure flag is set for all symbols in the C1 code word. The output data of the C1 decoder together with the erasure flags are further processed in the deinterleaver circuit, realised as delay lines of unequal length. In the deinterleave circuit the erasure flag of each symbol from the C1 decoder is being deinterleaved together with its associated data symbol. The output of the deinterleave circuit is supplied to a C2 decoder. In the C2 decoder, erasure correction of up to four errors is executed using the C1 erasure flags. If the C2 decoder can correct up to four error symbols then the C1 erasure flags are cleared. If C2 decoder can't correct the code word, either the C1 erasure flags are copied to the C2 code word or all erasure flags of C2 code word are set. The last stage in the CIRC decoding is a two-symbol delay executed by the two-symbol delay circuit.

Considering the number of clock cycles needed to process one frame, operations of the known CIRC decoder of WO 02/069505 for processing CIRC correction code include the following steps: 1) If sufficient data is available in the buffer of the input logic then a frame is stored into the correspondent bank of the M1 memory part of the RAM. This step needs 32 RAM write cycles. 2) Delay of one symbol is executed in the M1 memory by means of the Controller. Afterwards 32 symbols, i.e. one C1 code word, are transferred to the syndrome generator block, which starts the RS decoding process. The correction of up to 2 errors is executed in the RS decoder and the corrected C1 code word is stored into the M2 memory part of the RAM. This step needs 32 + 28 = 60 RAM read/write cycles. The KeySolver block and ChienSolver block need approximately 40 cycles for one decoding process. 3) The M2 part of the RAM is used for deinterleaving and assembling the C1 code words into C2 code words. Deinterleaving process is performed by addressing the M2 memory and transferring 28 symbols, i.e. one C2 code word, to decoding and correction in the the RS decoder. Up to 4 erasures are corrected in the RS decoder and the corrected C2 code word is stored into the M3 memory part of the RAM. This step needs 28 + 28 = 56 RAM read/write cycles. The KeySolver block and ChienSolver block need approximately 40 cycles for one decoding process. 4) The output of the M3 memory is loaded into the output logic and then delay of 2 symbols is executed in the M3 memory by means of appropriate control. This step needs 24 + 24 + 24 = 72 RAM read/write cycles. A total of 300 cycles are needed for processing CIRC correction code.

In the known single pass CIRC decoder of EP 1 388 946, memory areas "M1", "M2,a" and "M2,b" are controlled and addressed in parallel during read, write operations. The following steps are executed: 1) A frame is written into the M1 memory from the input logic, delay of one symbol is performed. This step needs 32 write cycles in the M1 memory. 2) A C1 code word is read from the M1 memory to the RS1 decoder, the RS1 decoder is started. This step needs 32 read accesses in the M1 memory. 3) Deinterleaving is performed in the M2,a memory: A C2 code word is read from the M2,a memory to the RS2 decoder, the RS2 decoder is started. This step needs 28 read accesses in the M2 memory. Because steps 2 and 3 are performed in parallel, 32 write cycles are needed in total. 4) The corrected C1 code word is loaded into the M2,a memory from the RS1 decoder. This step needs 28 write cycles in the M2,a memory. The KeySolver block and ChienSolver block need approximately 40 cycles for a decoding process. 5) The corrected C2 code word is loaded into the M3 memory from the RS2 decoder. This step needs 28 write accesses in the M3 memory. Because steps 4 and 5 are performed in parallel, 28 write cycles are needed in total. 6) The output of the M3 memory is loaded into the output logic and then delay of 2 symbols is executed in the M3 memory by means of appropriate control. This step needs 24 + 24 + 24 = 72 read/write cycles in the M3 memory. A total of 32 + 32 + 28 + 40 + 72 = 204 cycles are needed for processing CIRC correction code.

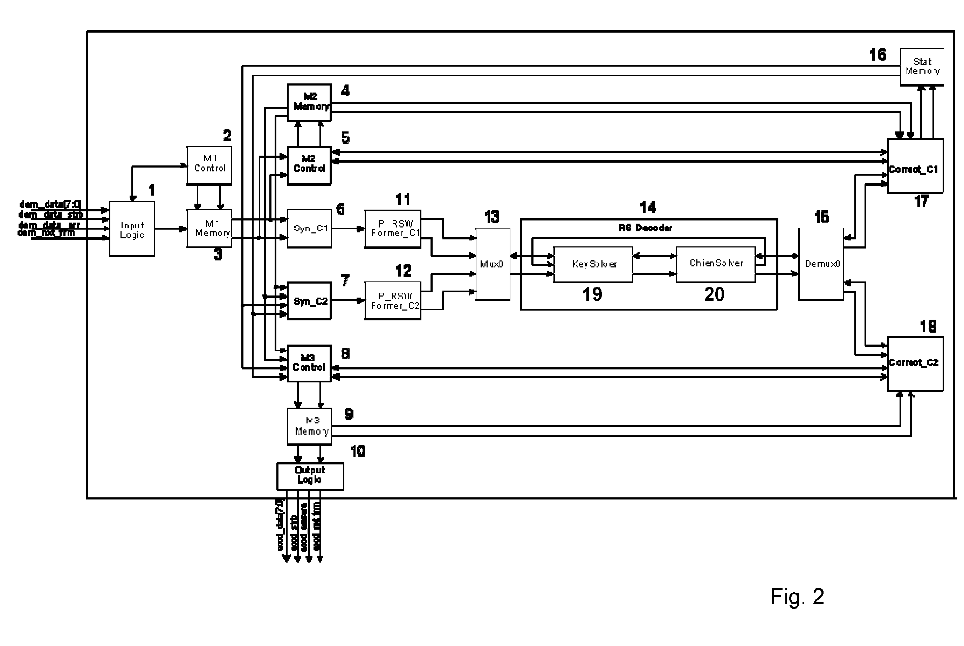

Fig. 2 shows the block diagram of a CIRC decoder according to the invention, comprising the following components:
- An Input logic 1 used to receive symbols from a data acquisition stage which may comprise a demodulator or an IF stage in case of a transmission reception, and to combine these symbols into frames. The input logic 1 is capable to store symbols of 2 x 32 x 9 bits.
- An M1 memory 3 and an M1 control unit 2, used to perform the delay of one symbol. The size of the M1 memory 3 is 32 x 3 x 9 bits.
- An M2 memory 4 and an M2 control unit 5, used to execute the deinterleaving. The size of the M2 memory is 110 x 32 x 8 bits.
- A C1 Syndrome Generator 6, used to compute erasure positions and a syndrome set for a C1 code word.
- A P_RSW Former_C1 11, used to form the RSW package of a C1 code word for use in an RS Decoder 14.
- A C2 Syndrome Generator 7, used to compute erasure positions and a syndrome set for a C2 code word.
- A P_RSW Former_C2 12, used to form the RSW package of a C2 code word for use in the RS Decoder 14.
- An M3 memory 9 and an M3 control unit 8, used to execute the delay of two symbols. The size of the memory is 28 x 9 + 24 x 9 bits.
- The RS Decoder 14, where according to the invention only one single RS Decoder circuit 14 is used for correcting the C1 and C2 codewords. The C1 and C2 syndromes are supplied in time-multiplex to the RS Decoder 14. The RS Decoder 14 comprises a Key Equation Solver or KeySolver 19 and a ChienSolver 20 and is capable to decode and correct up to 2 errors, 4 erasures and combinations of erasures and errors like 1 erasure + 1 error, or 2 erasures + 1 error.
- A Mux0 multiplexer 13, used to select an input from either the P_RSW Former_C1 11 or from the P_RSW Former_C2 12 and to output it to the RS Decoder 14.
- A Demux0 demultiplexer 15, used to transfer the error values and error positions either to the Correct_C1 Correction block 17 or to the Correct_C2 correction block 18.
- A Status Memory 16, used to store the decoding result of C1 codewords. If the decoding result is successful then "0" is stored into the Status Memory 16, otherwise, i.e. in case of decoding failure, "1" is stored. The size of the Status Memory 16 is 110 x 1 bits.
- A Correct_C1 Correction block 17, used to correct erroneous bytes of C1 code words. The erroneous bytes are transferred from the M2 memory 4 to the Correct_C1 correction block 17, are being corrected and are written back into the M2 memory 4.
- A Correct_C2 Correction block 18, used to correct erroneous bytes of C2 code words. The erroneous bytes are transferred from the M3 memory 9 to the Correct_C2 correction block 18, are being corrected and are written back into the M3 memory 9.
- An Output Logic 10, used to store the 24 symbols of output data of the M3 memory 9.

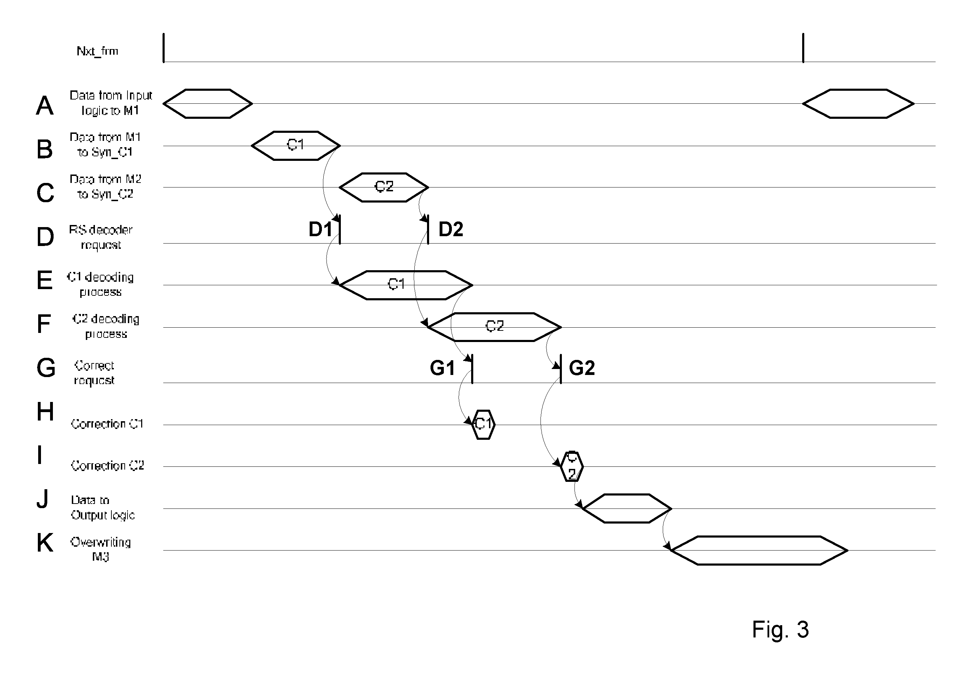

Fig. 3 shows the main data flow of the CIRC decoder according to the invention. One can distinguish between two independent processes, namely the C1 decoding and correcting process executed in the series of the blocks C1 Syndrome Generator shown as 6 in Fig. 2, P_RSW Former_C1 11, RS Decoder 14, Correct_C1 17, M2 memory 4; and the C2 decoding and correcting process executed in the series of blocks C2 Syndrome Generator 7, P_RSW Former_C2 12, RS Decoder 14, Correct_C2 18, M3 memory 9. Due to pipeline effect, the two processes are working in parallel, for example a KeySolver task for C1 being performed in the KeySolver 19 of the RS Decoder 14, and a ChienSolver task for C2 being performed in the ChienSolver 20. Alternatively, the KeySolver 19 performs for C2 and the ChienSolver 20 performs for C1.

If the next_frame signal is active then a frame is loaded A from the input logic 1 into the M1 memory 3. Data from the M1 memory 3 is transferred B to the C1 Syndrome Generator 6, data from the M2 memory 4 is transferred C to the C2 Syndrome Generator 7. If the syndrome set for C1 has been calculated then the C1 Syndrome Generator 6 generates a first impulse D1 on the "RS decoder request" signal D. The RS Decoder 14 acknowledges the request and starts E the C1 decoding process. If the decoding process has been finished the RS Decoder 14 generates a second impulse G1 on the "Correct request" signal G. The correct_c1 block 17 acknowledges the request and starts H the correction process. The Correct_C1 block 17 corrects the data in the M2 memory 4.

If the syndrome set for C2 has been calculated then the C2 Syndrome Generator 7 generates a third impulse D2 on the "RS decoder request" signal D. The RS Decoder 14 acknowledges the request and starts F the C2 decoding process. If the decoding process has been finished then the RS Decoder 14 generates a fourth impulse G2 on the "Correct request" signal G. The Correct_C2 Correction block 18 acknowledges the request and starts I the correction process. The Correct_C2 Correction block 18 corrects the data in the M3 memory 9. The data from M3 memory 9 are transferred J to the output logic 10 and the M3 memory 9 is overwritten K with next data.

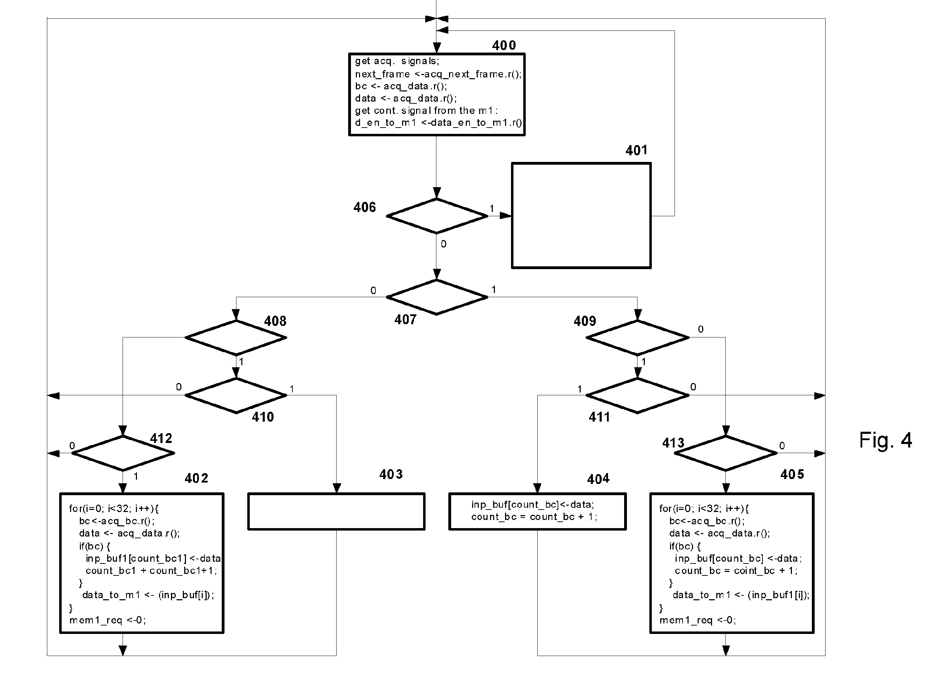

Fig. 4 shows a flowchart of the sequence of operations in the input logic 1. The Input logic 1 has two buffers, each capable to store 32 x 9 bits, namely 8 bits of data plus 1 bit erasure flag. One buffer is used to assemble incoming data from the acquisition block into frames, the other buffer is used to transfer a completed frame to the M1 memory 3. Both buffers are switched or interchanged if the acq_next_frame signal 505 is active.

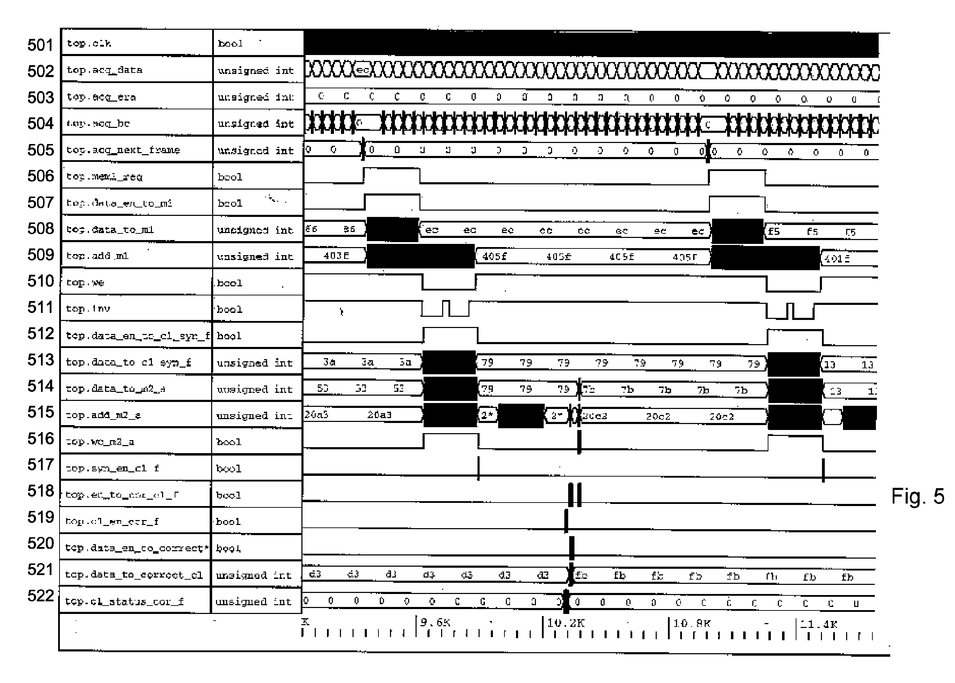

Fig. 5 shows a timing diagram explaining the Data flow in the input buffer. If the acq_next_frame signal 505 is active then the Input logic 1 generates the memory 1 request mem1_req 506. The data_en_to_m1 signal 507 from the M1 control unit 2 acknowledges the receipt of the mem1_req signal 506 and enables the transfer of a frame, i.e. 32 symbols, from the first buffer to the M1 memory 3. The acq_bc signal 504 is analyzed during transferring a frame. If the acq_bc signal 504 is active, the transferring is interrupted and the current symbol from the acquisition block is loaded into the second buffer. All this corresponds to step 402 of Fig. 4. Afterwards the transmission of symbols is continued. If 32 symbols have been transferred to the M1 memory 3 then the mem1_req signal 506 and the data_en_to_m1 signal 507 are set to zero. Loading symbols from the acquisition block into the second buffer is continued after transferring 32 symbols from the first buffer, corresponding to step 403 of Fig. 4. The acq_next_frame signal 505 switches or interchanges both buffers and the N_ib signal is set to 1 meaning active, to switch over to the part of the flowchart of Fig. 4 comprising steps 404 and 405.

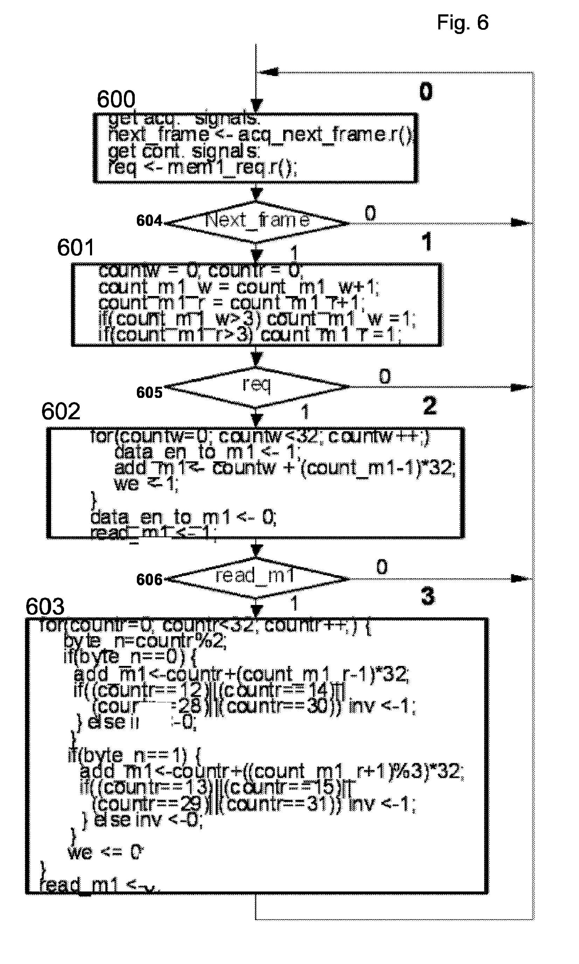

Fig. 6 shows a flowchart of the sequence of operations related to the M1 Control unit 2, the functionality of which is also explained by the timing diagram of Fig. 5. The M1 Control unit 2 and the M1 memory 3 are used to execute the delay of 1 symbol process. The M1 Control unit 2 has to perform the following tasks: 1) Controlling the data exchange between the M1 memory 3 and other blocks during read/write operations; 2) Inversion operation; 3) Addressing data in the M1 memory 3 during read/write operations; 4) Controlling the M1 memory 3.

The data_en_to_m1 signal 507 from the M1 control unit 2 acknowledges the receipt of the mem1_req signal 506 and enables transferring a frame, i.e. 32 symbols, from the input logic 1 to the M1 memory 3, corresponding to step 602. At the same time consecutive addresses add_m1 509 are generated during write cycles of the M1 memory 3. With a high or active level, the write enable control signal we 510 enables to write data_to_m1 508 into the M1 memory 3. After the write cycles the read_m1 signal is generated, which starts the inversion or negation operation in the M1 memory 3 in step 603. Data is inverted depending on the reading of the counter countr: if countr is between and including 12 and 15, or if countr is between and including 28 and 31, data is inverted. The associated erasure bit is not inverted. The inv signal 511 controls the inversion operation. At the same time consecutive addresses add_m1 509 are generated during read cycles of the M1 memory 3. With a low or inactive level, the write enable control signal we 510 enables to read data_to_c1_syn from the M1 memory 3. During step 601 bank addresses count_m1_w, count_m1_r of the M1 memory 3 are generated.

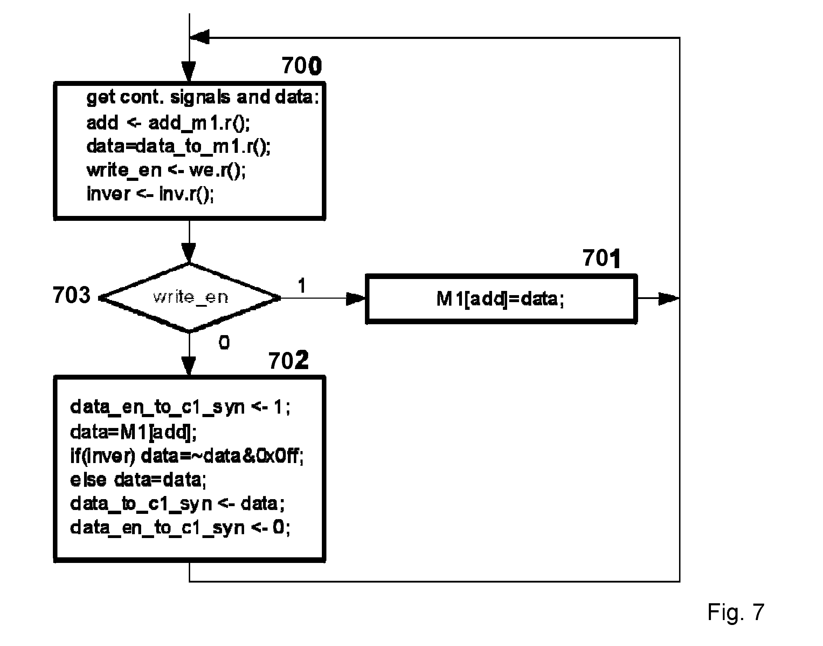

Fig. 7 shows a flowchart of the sequence of operations in the M1 memory 3 which comprises three banks with the addresses 0, 1, and 2. Each bank contains 32 symbols of 9 bits each. The most significant or MS bit is the "erasure flag", the bits 0 to 7 are the data. An erasure bit or flag indicates that a symbol is corrupted. Counters count_m1_w and count_m1_r define the bank addresses during write/read cycles of the M1 memory 3. Data from the M1 memory 3 is transferred to the C1 Syndrome Generator 6 and to the M2 memory 4 in parallel. The signal data_en_to_c1_syn 512 enables to write a data data_to_c1_syn 513 from the M1 memory 3 into the M2 memory 4 and into the C1 syndrome generator 6. The M2 memory 4 gets the addresses add_m1 509 and the control signal we 510 from the M1 control unit 2.

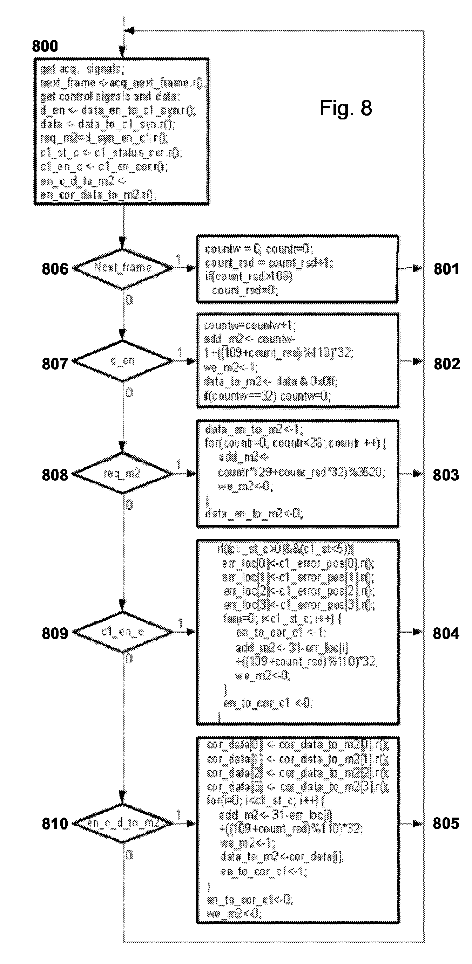

Fig. 8 shows a flowchart of the sequence of operations related to the M2 control unit 5, the functionality of which is also explained by the timing diagram of Fig. 5. The M2 control unit 5 and the M2 memory 4 are used for the deinterleaving and the assembling of C1 code words into C2 code words. The M2 Control unit 5 has to perform the following tasks: 1) Controlling the data exchange between the M2 memory 4 and other blocks during read/write operations; 2) Addressing data in the M2 memory 4 during read/write operations; 3) Controlling the M2 memory 4. A C-like syntax is used in the flowcharts of Figs. 4, 6, 7, 8, 9, 12-16. Accordingly, "==" stands for the comparison or equal operator, "=" stands for a value assignment, "%" stands for integer division, "| |" stands for a logical or conjunction, a prefix "0x" indicates the following value as a hexadecimal number, "&" stands for a bitwise and conjunction, "&&" stands for a logical and conjunction. Additionally, "<-" stands for a signal or port output operation.

During step 807 the condition d_en=1 is checked. If this condition is "true" then, in step 802, data_to_c1_syn data 513 from the M1 memory 3 is written into the M2 memory 4. The data_en_to_c1_syn signal 512 from the M1 memory 3 enables the transferring of 32 symbols to the M2 memory 4. Consecutive addresses add_m1 509 are generated during write cycles of the M2 memory 4. With its high level, the control signal we 510 enables to write data into the M2 memory 4.

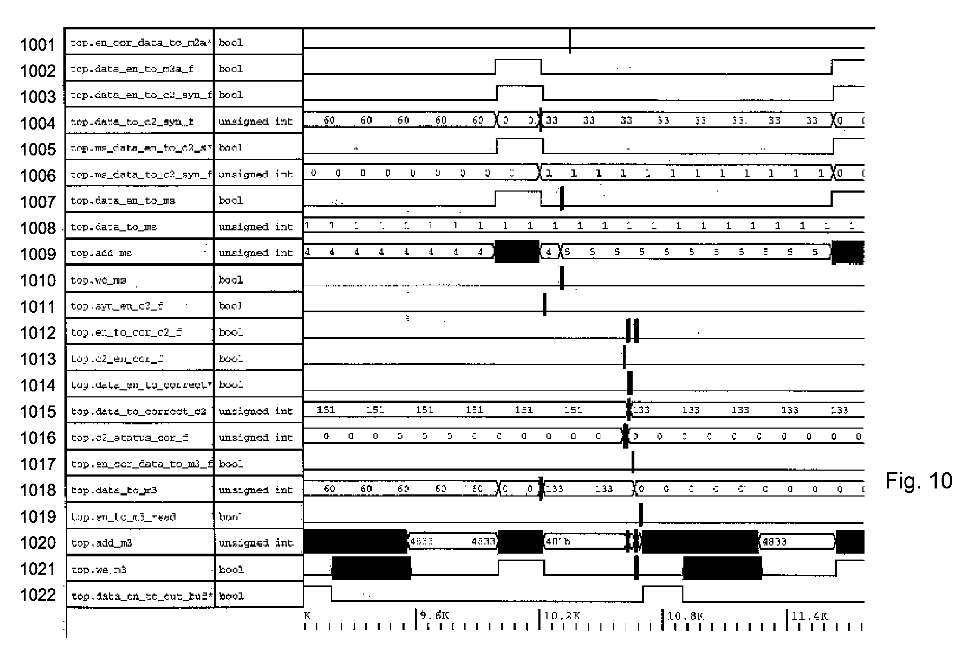

During step 808 the req_m2 condition is checked. If a syndrome set has been calculated then the C1 Syndrome Generator 6 provides the syn_en_c1 signal 517 and the req_m2 condition is "true". In this case in step 803 the deinterleaver process is started. Data from the M2 memory 4, namely 28 symbols of a C2 code word, is transferred to the C2 Syndrome Generator 7 and to the M3 memory 9 in parallel. The data_en_to_m2 1002 enables to read data from the M2 memory 4, see also Fig. 10.

During step 809 the condition c1_en_c=1 is checked. This condition indicates that the error positions are known in the Correct_C1 Correction block 17. In this case in step 804 error positions are transferred from the Correct_C1 Correction block 17, addresses of erroneous bytes in the M2 memory 4 are calculated and sent to the M2 memory 4. Erroneous bytes data_to_correct_c1 521 are transferred from the M2 memory 4 to the Correct_C1 Correction block 17. The data_en_to_correct_c1 signal 520 enables the transferring of erroneous bytes.

During step 810 the condition en_c_d_to_m2=1 is checked. This condition indicates that an erroneous byte has been corrected and can be written back into the M2 memory 4. In this case in step 805 the corrected data are transferred to the M2 memory 4. The en_cor_data_to_m2 signal 1001 enables the transfer.

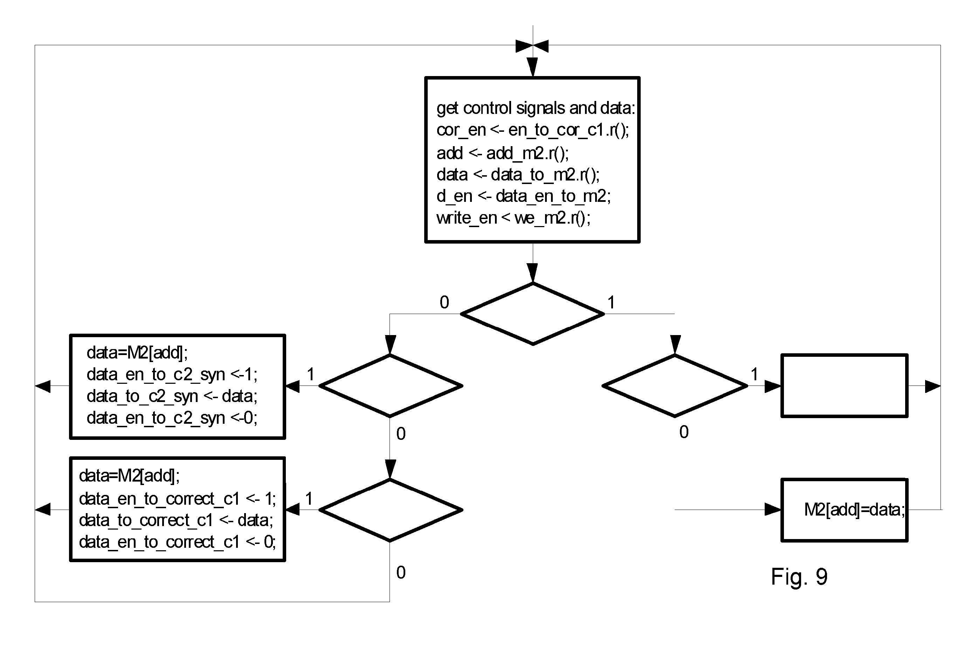

Fig. 9 shows a flowchart of the sequence of operations related to the M2 memory 4. The M2 memory 4 comprises 110 banks of 32 bytes each. During the write cycles the cor_en condition is analyzed in step 907. If this condition is "true" then the corrected bytes are written into the M2 memory 4 from the Correct_C1 Correction block 17 in step 902. If the condition is "false" then data from the M1 memory 3 is written into the M2 memory 4 in step 904. During the read cycles the d_en and cor_en conditions are analyzed in steps 906 and 908, respectively. If d_en=1 then the data data_to_c2_syn 1004 is read from the M2 memory 4 and forwarded to the C2 Syndrome Generator 7 in step 901. The data_en_to_c2_syn signal 1003 enables the transfer. If cor_en=1 then the erroneous data data_to_correct_c1 521 is read from the M2 memory 4 to the Correct_C1 Correction block 17 in step 903. The data_en_to_correct_c1 signal 520 enables the transfer.

The C1 Syndrome Generator 6 calculates the syndrome set of a C1 code word, calculates erasure positions in Galois field and also counts the number of erasures. 32 symbols of a C1 code word data_to_c1_syn 513 are transferred from the M1 memory 3 to the C1 syndrome generator 6. As shown in Fig. 5, the data_en_to_c1_syn signal 512 enables the transfer. The syn_en_c1 signal 517 indicates that the syndrome set has been calculated.

The P_RSW Former_C1 11 forms the RSW package of C1 code words for use in the RS Decoder 14. The RSW package of C1 code words, also denoted as c1_rsword, comprises the following components:
1. out.bank_nr=sing_s0; the parameter sing_s0 describes a single error in a C1 code word;
2. out.buf_nr=n_era_cor describes the number of erasures to the c1 correction block;
3. out_sy_om_err_val[]=syn_era_1[] is the syndrome set;
4. out_ers_err_pos[]=syn_era_1[] which is an erasure position;
5. out.nb_ers_err=n_era_kes which is the number of erasures to the KeySolver;
6. out.code_distance=4 which defines the number of parity symbols;
7. out.info=2 which indicates to process a C1 code word.

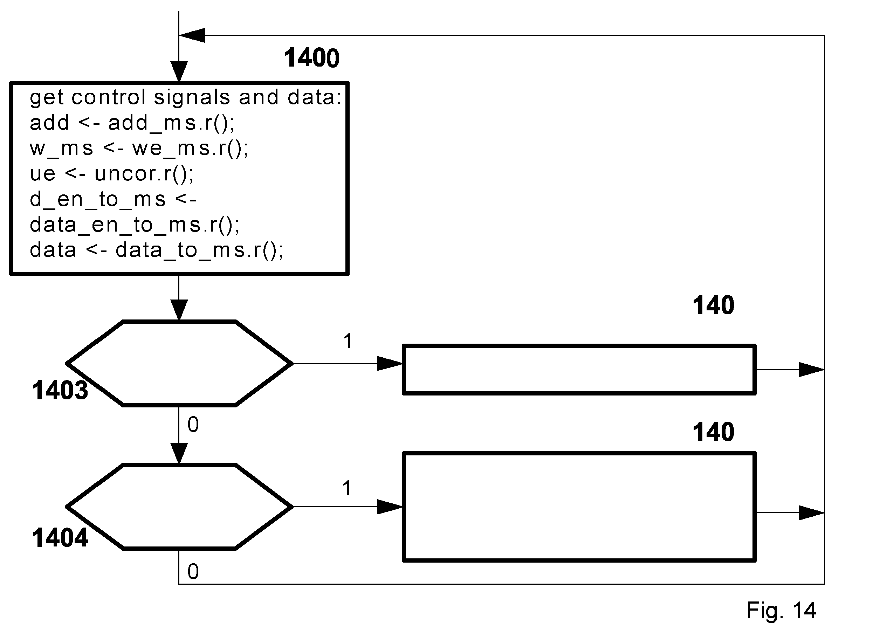

Fig. 10 shows a first timing diagram explaining the functionality of the Status Memory 16, Fig. 14 shows a flowchart of the related sequence of control operations. The Status Memory 16 is used to store the status of a C1 decoding process. The memory is capable to store 110 x 1 bits. If a C1 code word is uncorrectable, i.e. in cases of decoding failure, then "1" is stored into the memory. If the C1 frame is correctable then "0" is stored into the memory. The content of the Status Memory 16 is used later during the deinterleaving process. The data from the Status Memory 16 is read to the C2 Syndrome Generator 7.

The d_en_to_ms condition 1007 is analyzed in step 1403 and 1404 by evaluating the data_en_to_ms signal 1007. If it is "true" and a write cycle, as checked in step 1403, then the status of C1 decoding process from the correct_c1 block is written into the Status Memory 16 in step 1401. The data_en_to_ms signal 1007 enables to transfer the decoding status to the Status Memory 16. If data_en_to_ms=1 and read cycle, as checked in step 1404, then the data ms_data_to_c2_syn 1006 is read from the Status Memory 16 to the C2 Syndrome Generator 7. The ms_data_en_to_c2_syn signal 1005 enables the transfer. During the deinterleaving process, data from the Status Memory 16 and data from the M2 memory 4 are read in parallel. The address add_ms 1009 for the Status Memory 16 is generated. The control signal we_ms 1010, with its high level, enables to write data into the Status Memory 16; with its low level it enables to read data from the Status Memory 16.

The C2 Syndrome Generator 7 calculates a syndrome set of a C2 code word, calculates erasure positions in Galois field and also counts the number of erasures. 28 symbols of a C2 code word data_to_c2_syn 1004 are transferred from the M2 memory 4 to the C2 syndrome generator 7. The data_en_to_c2_syn signal 1003 in Fig. 10 enables the transfer. The decoding statuses of C1 code words ms_data_to_c2_syn 1006 from the Status Memory 16 are transferred to the C2 Syndrome Generator 7 to compute erasure positions. The ms_data_en_to_c2_syn signal 1005 enables the transfer. The syn_en_c2 signal 1011 indicates that the syndrome set has been calculated. Data from the M2 memory 4 and data from the Status Memory 16 are transferred in parallel to the C2 Syndrome Generator 7.

The P_RSW Former_C2 12 prepares the c2_rsword package for the RS Decoder 14. The c2_rsword package comprises the following components: 1) out.buf_nr=n_era_cor which is the number of erasures to the c2 correction block;
2) out_sy_om_err_val [] =syn_era_1 [] which is the syndrome set;
3) out_ers_err_pos[]=syn_era_1[] which is an erasure position;
4) out.nb_ers_err=n_era_kes which is the number of erasures to the KeySolver; 5) out.code_distance=4 which defines the number of parity symbols; 6) out.info=3 which indicates to process the c2 frame.

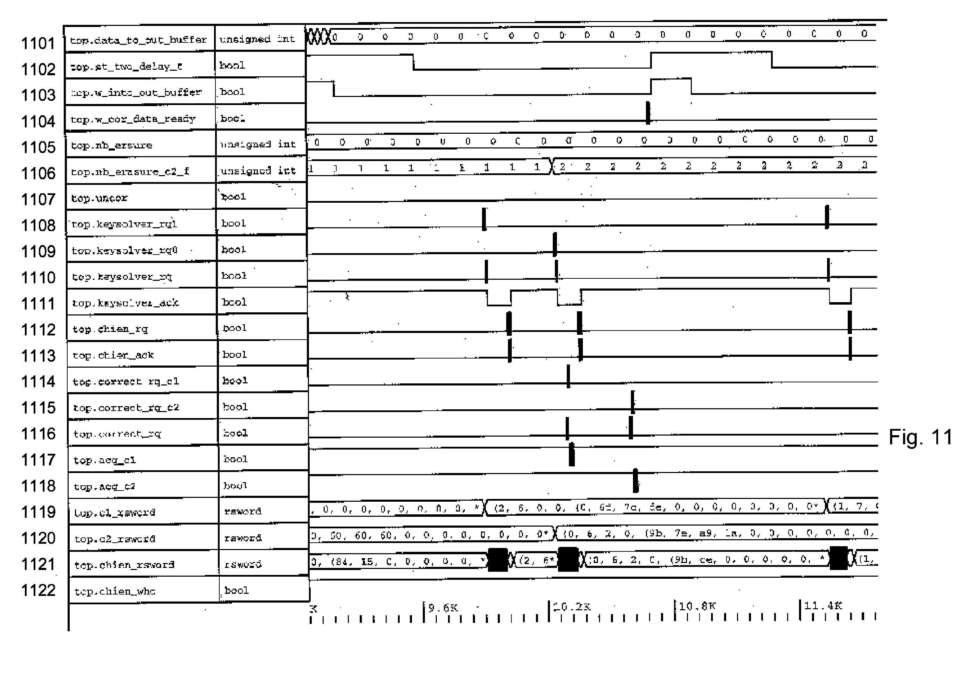

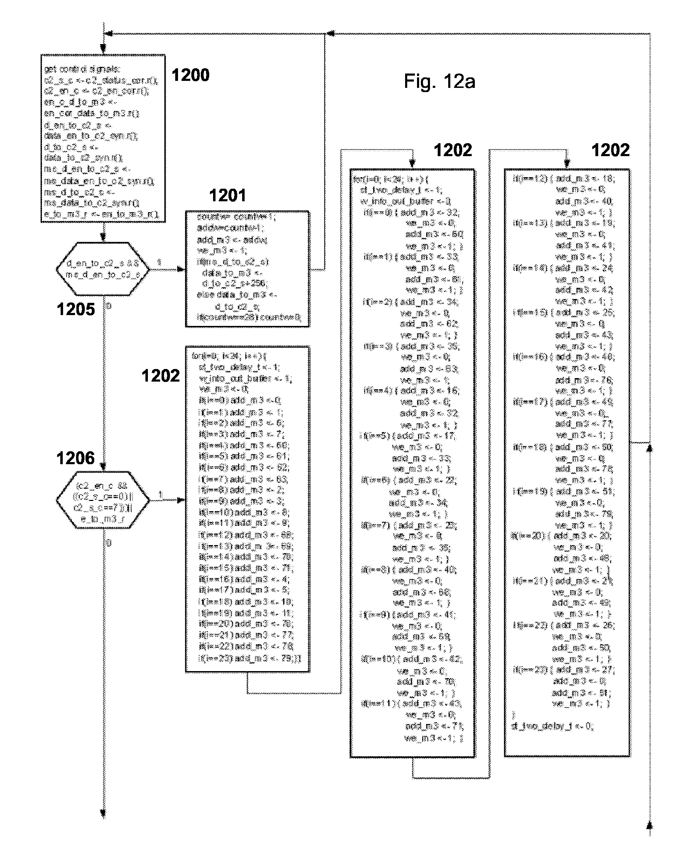

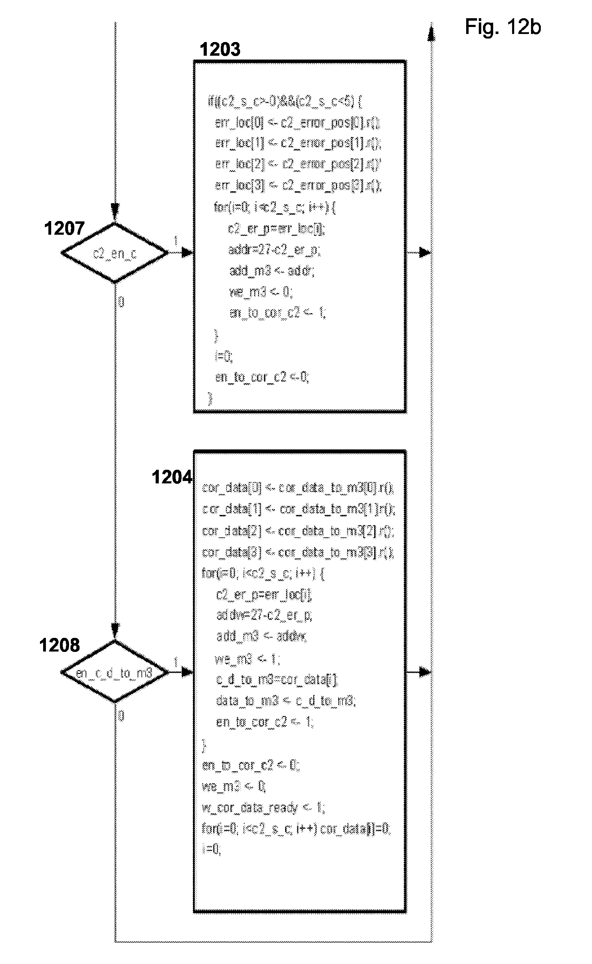

The timing diagram shown in Figs. 10 and 11 also explains the functionality of the M3 control unit 8. Figs. 12a and 12b show a flowchart which describes the sequence of related control operations. The M3 control unit 8 and the M3 memory 9 are used to execute the delay of two symbols task in the CIRC decoder. The M3 control unit 8 has to perform the following tasks:
1) Controlling data exchange between the M3 memory 9 and other blocks during read/write operations; 2) Addressing data in the M3 memory 9 during read/write operations; 3) Controlling the M3 memory 9.

During step 1205 the condition d_en_to_c2_s && ms_d_en_to_c2_s is checked by evaluating the signals data_en_to_c2_syn 1003 and ms_data_en_to_c2_syn 1005. If "true" then in step 1201 data from the M2 memory 4 and data from the Status Memory 16 are written into the M3 memory 9. The same data, namely 28 symbols of a C2 code word, is transferred to the C2 Syndrome Generator 7 in parallel. Consecutive addresses add_m3 1020 are generated during write cycles of the M3 memory 9. The control signal we_m3 1021 with high level enables to write data into the M3 memory 9.

During step 1206 the condition (c2_en_c && ((c2_s_c==0) | | (c2_s_c==7))) | | e_to_m3_r is checked by evaluating the signals c2_en_cor 1013, c2_status_cor 1016, and en_to_m3_read 1019, respectively. If this condition is "true" then in step 1202 the delay of two symbols task is started. The delay of two symbols task is started under the first part of the condition checked in step 1206, namely (c2_en_c && ((c2_s_c==0) | | (c2_s_c==7))), i.e. if in a C2 code word there are no errors or a C2 code word is uncorrectable. The c2_en_cor signal 1013 in Fig. 10 enables to transfer the error status of correction from the Correct_C1 Correction block 17 to the M3 control unit 8 of the M3 memory 9. If (c2_s_c>0)&&(c2_s_c<5), i.e. if the C2 correction status is between and including 1 and 4, then the Correct_C1 Correction block 17 starts to correct in the M3 memory 9 up to 4 errors. After the corrections, the en_to_m3 _read signal 1019 starts the delay of two symbols task. First of all 24 symbols of data data_to_out_buffer 1101 from the M3 memory 9 is transferred to the output logic 10. The data_en_to_out_buffer signal 1022 enables the transfer.

In step 1202 consecutive addresses add_m3 1020 are generated during read cycles of the M3 memory 9. The control signal we_m3 1021, with its low level enables to read data from the M3 memory 9. The overwriting the M3 memory 9 starts afterwards. Consecutive addresses add_m3 1020 are generated during read/write cycles of the M3 memory 9. The control signal we_m3 1021, with its low/high level enables to read/write data from/to the M3 memory 9 as shown in Fig. 10.

During step 1207 in Fig. 12b the condition c2_en_c=1 is checked by evaluating the c2_en_cor signal 1013. If true, the error status is checked: If (c2_s_c>0)&&(c2_s_c<5), i.e. if the C2 correction status is between and including 1 and 4, then the Correct_C2 correction block 18 indicates that the error positions are known. In this case error positions are transferred from the Correct_C2 Correction block 18 to the M3 control unit 8. Addresses of erroneous bytes in the M3 memory 9 are calculated and sent to the M3 memory 9. Erroneous bytes data_to_correct_c2 1015 are transferred from the M3 memory 9 to the Correct_C2 correction block 18. The data_en_to_correct_c2 signal 1014 enables the transfer of erroneous bytes.

During step 1208 the condition en_c_d_to_m3=1 is checked by evaluating the en_cor_data_to_m3 signal 1017, indicating that erroneous bytes have been corrected and can be written back into the M3 memory 9. In step 1204 the corrected data are transferred to the M3 memory 9. The en_cor_data_to_m3 signal 1017 enables the transfer.

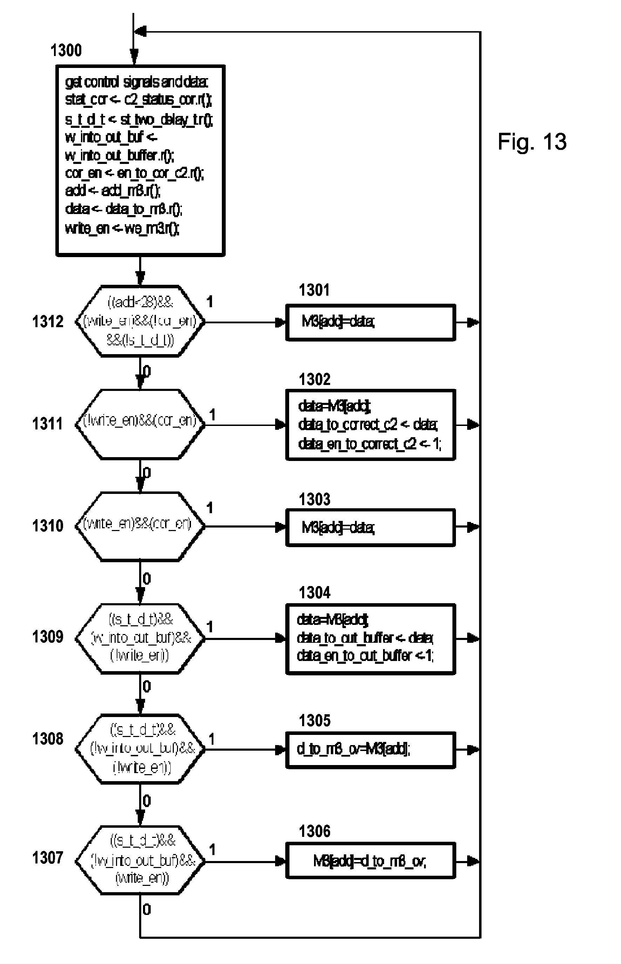

Fig. 13 shows a flowchart describing the sequence of operations related to the M3 memory 9. The M3 memory 9 is capable to store the 76 x 9 bits. During step 1312 the condition (write_en)&& (!cor_en)&& (!s_t_d_t) is checked by evaluating the signals we_m3 1021, en_to_cor_c2 1012, and st_two_delay_t 1102, respectively. If "true", then in step 1301 data from the M2 memory 4, 28 symbols, are selected and written into the M3 memory 9. During step 1311 the condition (!write_en)&&(cor_en) is checked. If "true" then in step 1302 the erroneous bytes from the M3 memory 9 are transferred to the Correct_C2 correction block 18. During step 1310 the condition (write_en)&&(cor_en) is checked. If "true" then in step 1303 the corrected bytes from the Correct_C2 correction block 18 are transferred to the M3 memory 9.

### During step 1309 the condition

((s_t_d_t)&& (w_into_out_buf)&&(!write_en)) is checked by evaluating the signals st_two_delay_t 1102, w_into_out_buffer 1103, and we_m3 1021, respectively. If "true" then in step 1304 data from the M3 memory 9 is transferred to the output logic 10. Overwriting the M3 memory 9 is performed during steps 1305 and 1306.

The Mux0 multiplexer 13 selects either the output of the P_RSW Former_C1 11 or the output of the P_RSW Former_C2 12 and connects it to the input of the RS decoder 14. If the P_RSW Former_C1 11 is ready to transfer a package to the RS decoder 14, the Mux0 multiplexer 13 generates a keysolver_rq1 pulse shown as 1108 in Fig. 11. If the P_RSW Former_C2 12 is ready to transfer a package to the RS decoder 14, the Mux0 multiplexer 13 generates the keysolver_rq0 pulse 1109. The keysolver_acq signal 1111 acknowledges that the corresponding package has been accepted and starts the RS decoding process.

The Demux0 demultiplexer 15 connects the output of the RS decoder 14 to the input of either the Correct_c1 correction block 17 or the Correct_c2 correction block 18. The correct_rq signal shown as 1116 in Fig. 11 indicates that the RS decoder 14 has a correction request to a correction block, with other words it indicates that error positions and error values are known in the RS decoder 14. The out.info parameter in the output package defines to which correction block the request is destined: If out.info=2 then the Demux0 demultiplexer 15 generates the correct_rq_c1 signal 1114, if out.info=3 then the Demux0 demultiplexer 15 generates the correct_rq_c2 signal 1115. If the correct_rq_c1 signal 1114 is active then the error positions and the error values are transferred from the RS decoder 14 to the Correct_C1 correction block 17. The acq_c1 signal 1117 acknowledges that the correct_rq_c1 signal 1114 has been observed and the error positions and the error values have been accepted in the Correct_C1 correction block 17. After that the C1 error correction process is started. If the correct_rq_c2 signal 1115 is active then the error positions and the error values are transferred from the RS decoder 14 to the Correct_C2 correction block 18. The acq_c2 signal 1118 acknowledges that the correct_rq_c2 signal 1115 has been observed and the error positions and the error values have been accepted in the Correct_C2 correction block 18. After that the C2 error correction process is started.

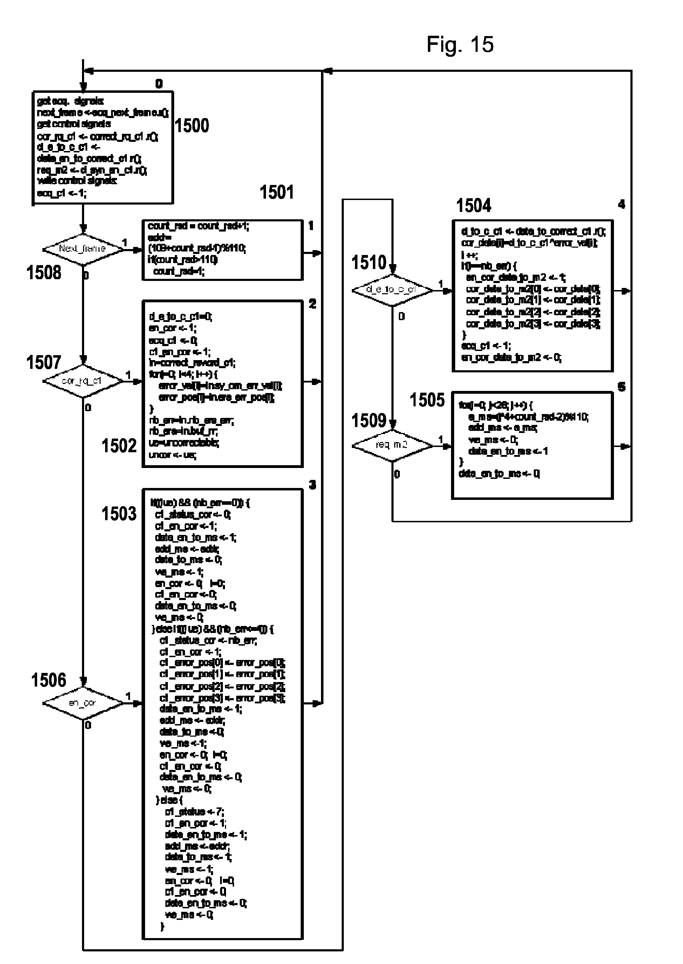

Fig. 15 shows a flowchart describing the sequence of control operations related to the Correct_C1 block 17. The timing diagram in Fig. 5 also explains the functionality of this block.

The Correct_C1 correction block 17 performs the following tasks: 1) Controlling data exchange between itself and other blocks during read/write operations; 2) Writing the C1 error positions and the error status into the M2 Control Unit 5. 3) Reading erroneous data bytes from the M2 memory 4 to its correction buffer; 4) Correcting erroneous bytes; 5) Writing the corrected bytes into the M2 memory 4; 6) Controlling the Status Memory 16; 7) Generating the memory addresses during the read/write cycles depending on the task.

The acq_next_frame signal 505 is evaluated in step 1508 to check the Next_frame condition. If "true", addresses of the status memory during write/read cycles are computed in step 1501. In step 1507, the correct_rq_c1 signal 1114 is evaluated to check the cor_rq_c1 condition which indicates that the RS decoder 14 requests the Correct_C1 Correction block 17 to become active, because error positions and error values are known. The acq_c1 signal 1117 acknowledges that the correct_rq_c1 signal 1114 has been observed and that the error positions and the error values have been accepted in the Correct_C1 Correction block 17. During step 1502 the error positions error_pos[i], the error values error_val[i] and the decoding status are transferred from the RS decoder 14 to the Correct_C1 Correction block 17. The decoding status is described by the number of errors nb_err and by the uncorrectable signal uncor 1107. Uncor=0 is defined to indicate that the decoding process was successful, other values indicate that there was a decoding failure.

The c1_en_cor signal 519 is generated after the required information has been buffered in the Correct_C1 Correction block 17. During step 1503 the decoding status is checked. If (!ue)&&(nb_err==0) then the c1_status_cor signal 522 is set to "0". The high level of the c1_en_cor signal 519 enables to transfer the error status to the M2 Control Unit 5. The address add_ms 1009 for the Status Memory 16 is generated depending on the count_rsd counter. The data_to_ms 1008 is set to "0", and the data_en_to_ms signal 1007 and the we_m3 control signal 1021, with their high level, enable to write it into the Status Memory 16.

If (!ue)&&(nb_err<=4) then the c1_status_cor signal 522 is set to the number of errors nb_err. The high level of the c1_en_cor signal 519 enables to transfer the error status and the error positions to the M2 Control Unit 5. The bus between the M2 control Unit 5 and the Correct_C1 Correction block 17 is a parallel bus, therefore one write cycle is needed to transfer the error positions and the error status from the Correct_C1 Correction block 17 to the M2 Control Unit 5.

Addresses of erroneous bytes in the M2 memory 4 are calculated according to error positions and are sent to the M2 Memory 4. The erroneous bytes data_en_to_correct_c1 520 are transferred from the M2 Memory 4 to the Correct_C1 Correction block 17. The data_en_to_correct_c1 signal 520 enables to transfer the erroneous bytes. Four read cycles are needed to read erroneous bytes from the M2 Memory 4 and transfer them to the Correct_C1 Correction block 17. The address add_ms 1009 for the Status Memory 16 is generated depending on the count_rsd counter. The data_to_ms 1008 is set to "0", and the data_en_to_ms signal 1007 and the we_m3 control signal 1021, with their high level, enable to write it into the Status Memory 16. If (ue==1), which indicates an uncorrectable code word, then the c1_status_cor signal 522 is set to "7", and data_to_ms 1008 is set to "1" and written into the Status Memory 16.

During step 1510 the data_en_to_correct_c1 signal 520 is evaluated to check the condition d_e_to_c_c1. If "true", the erroneous bytes are fetched from the M2 Memory 4, are corrected, and are sent back to the M2 Memory 4. The en_cor_data_to_m2 signal 1001 enables to transfer corrected data from the Correct_C1 Correction block 17 to the M2 Memory 4. The bus between the M2 Control Unit 5 and the Correct_C1 Correction block 17 is a parallel bus, therefore one write cycle is needed to transfer the corrected bytes.

During step 1505 the Status Memory 16 is being controlled and addressed. Consecutive addresses add_ms 1009 are generated during read cycles of the M2 Memory 4. A "low" or "0" level at the we_ms control signal 1010, and a "high" or "1" level at the data_en_to_ms signal 1007 enable to read data from the M2 Memory 4.

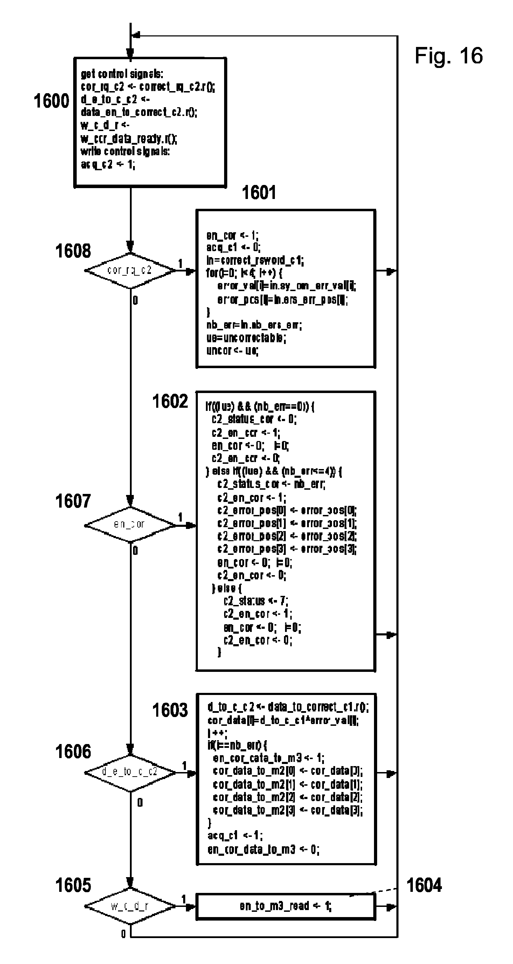

Fig. 16 shows a flowchart describing the sequence of control operations related to the Correct_C2 Correction block 18. The timing diagrams of Figs. 10 and 11 additionally explain the functionality of this block. The Correct_C2 Correction block 18 performs the following tasks: 1) Controlling data exchange between itself and other blocks during read/write operations; 2) Writing the C2 error positions and the error status into the M3 Control Unit 8. 3) Reading erroneous bytes of data from the M3 memory 9 into its own correction buffer; 4) Correcting erroneous bytes; 5) Writing the corrected bytes into the M3 memory 9; 6) Calculating the addresses during the read/write cycles depending on the task.

The correct_rq_c2 signal 1115 is evaluated in step 1608 of Fig. 16 to check the cor_rq_c2 condition. It indicates that the RS decoder 14 requests the Correct_C2 Correction block 18 to become active, because error positions and errors values are known. The acq_c2 signal 1118 acknowledges that the correct_rq_c2 signal 1115 has been observed and that the error positions and the error values have been accepted in the Correct_C2 Correction block 18. During step 1601 the error positions, error values and decoding status are transferred from the RS decoder 14 to the Correct_C2 Correction block 18. The decoding status comprises the number of errors and an "uncor" signal 1107; uncor=0 is defined to indicate that the decoding process was successful, other values indicate a decoding failure.

The c2_en_cor signal 1013 is generated after all the needed information has been buffered in the Correct_C2 Correction block 18. During step 1607 the decoding status is checked within the Correct_C2 Correction block 18. In step 1602, if (!ue)&&(nb_err==0) then the c2_status_cor signal 1016 is set to 0. The high level of the c2_en_cor signal 1013 enables to transfer the error status to the M3 Control Unit 8. If (!ue)&&(nb_err<=4), i.e. if not uncorrectable and the number of errors is less or equal to 4, then the c2_status_cor signal 1016 is set to the number of errors nb_err. The high level of the c2_en_cor signal 1013 enables to transfer the error status and the error positions to the M3 Control Unit 8. Because the bus between the M3 control Unit 8 and the Correct_C2 Correction block 18 is a parallel bus, one write cycle is needed for the transfer.

Addresses of erroneous bytes in the M3 Memory 9 are calculated in the M3 control Unit 8 according to error positions and are sent to the M3 memory 9. Erroneous bytes data_to_correct_c2 1015 are transferred from the M3 memory 9 to the Correct_C2 Correction block 18. The data_en_to_correct_c2 signal 1014 enables to transfer the erroneous bytes. Four read cycles are needed to read the erroneous bytes and to transfer them from the M3 memory 9 to the Correct_C2 Correction block 18. If (ue==1), indicating an uncorrectable codeword, then the c2_status_cor signal 1016 is set to "7".

During step 1606 the data_en_to_correct_c2 signal 1014 is evaluated to check the condition d_e_to_c_c2. If "true" then in step 1603 erroneous bytes are read from the M3 memory 9, are corrected and are sent back to the M3 memory 9. The en_cor_data_to_m3 signal 1017 enables to transfer corrected data from the Correct_C2 Correction block 18 to the M3 Memory 9. Because the bus between the M3 Control Unit 8 and the Correct_C2 Correction block 18 to transmit the corrected bytes is a parallel bus, one write cycle is needed to transfer the corrected data. During step 1605 the condition w_c_d_r=1 is checked by evaluating the w_cor_data_ready signal 1104. This condition means that corrected data have been stored in the M3 memory and the delay of two symbols task in the M3 memory 9 can be started. The en_to_m3_read signal 1019 is set to "1".

The RS Decoder 14 can correct RS(32,28,5) and RS(28,24,5) codes. It comprises the sub blocks KeySolver 19 and ChienSolver 20. Each sub block is as autonomous as possible; it waits for a request from a demander, starts its operation upon such request, and when the task is finished it returns to the idle state, possibly requesting some activity from a subsequent module. In that way a pipeline structure is achieved, where every block can work in parallel with the other. The performance is limited by the speed of the slowest block, processing one codeword. The slowest block in the chain is the ChienSolver 20, it needs a maximum of 28 cycles for processing one code word. Therefore RS decoding can be divided into a two-stage pipeline. The first pipeline process performed in the KeySolver 19 comprises the following decoding steps: Constructing the erasure polynomial; constructing the modified syndrome polynomial; initializing the modified Euclid algorithm with the modified syndrome and erasure polynomial; computing the error magnitude polynomial and errata polynomial by solving the key equation. The second pipeline process performed in the ChienSolver 20, comprises the following decoding steps: Searching roots of the errata polynomial and computing error magnitude values by using Forney's equation.

The KeySolver 19 receives the syndrome and erasure set from the C1 Syndrome Generator 6 or the C2 Syndrome Generator 7 via the P_RSW Former_C1 11, P_RSW Former_C2 12, and the Mux0 multiplexer 13, additionally it receives information about code word itself, e.g. the code word number, the number of erasures, whether or not the code word was uncorrectable, whether or not to bypass the decoder, etc.

First the KeySolver 19 multiplies the syndrome polynomial with each erasure position. The resulting polynomial is called the modified syndrome polynomial. In parallel the KeySolver 19 constructs the erasure polynomial. A modified Euclid algorithm is initialized by both resulting polynomials. The Euclid circuit solves the Key Equation after certain steps. Due to the modified Euclid algorithm the errata polynomial, which is the product of the error locator polynomial and the erasure polynomial is directly obtained at the end of the Euclid algorithm. Finally the error magnitude polynomial and the errata polynomial are ready to be transferred to the ChienSolver 20. The KeySolver 19 requests the ChienSolver 20 to become active and waits for its acknowledge signal.

The ChienSolver 20 receives the errata polynomial, the error magnitude polynomial and information about the code word via handshaking from the KeySolver 19. It searches the roots of the errata polynomial and computes the error values according to Forney's equation. For this, the Chien algorithm is used, each possible root location is tested by hardware. If the polynomial evaluates to zero at the tested root location, the error value is computed and saved in a register. Additionally the ChienSolver 20 counts the total errors. After stepping through all possible roots the ChienSolver 20 decides, whether the code word is correctable or not. The results are delivered via the Demux0 demultiplexer 15 to either the Correct_C1 Correction block 17 or to the Correct_C2 Correction block 18 via handshaking.

In summary, using parallel-pipelined control operations and reducing the number of write/read cycles in three separate working memories allows to achieve, with one RS decoder, the same CIRC decoding speed as the known solution of EP1388946, at a reduced hardware and memory size. The total size of the M2 memory and the status memory used for deinterleaving is smaller than in a conventional deinterleaver: In the conventional deinterleaver, memory has 28 x 110 x 9 = 27720 bits, 8 of the 9 bits being data and 1 bit being an erasure flag. In the deinterleaver according to the invention, the memory is 28 x 110 x 8 + 110 = 24750 bits. The same speed is achieved due to the invented CIRC decoding process as shown in Fig. 3: 1) A frame is written into the M1 memory from the input logic, delay of one symbol is performed. This needs 32 write cycles in the M1 memory. 2) Data from the M1 memory is transferred to the syn_c1 syndrome generator and to the M2 memory in parallel. This needs 32 cycles. 3) A c1 decoding process is started in the RS decoder at the request of the syn_c1 syndrome generator. Two additional processes are executed in parallel with the c1 decoding process, namely data from the M2 memory is transferred to the syn_c2 generator and to the M3 memory. The longest of these processes defines the number of cycles this step needs. It is the decoding process, needing approximately 40 cycles. 3) At the request of the syn_c2 generator, the KeySolver within the RS decoder then starts a C2 decoding process. Concurrently, the C1 decoding process is continued in the ChienSolver block of the RS decoder. At the request of the ChienSolver block, the correction process in the correct_c1 correction block is started. In total this step needs 40-12=28 cycles. 4) At the request of the ChienSolver block, the correction process in the correct_c2 correction block is started. This step needs 1+4+1=6 cycles. 5) Output of the M3 memory is loaded into the output logic and then the delay of 2 symbols is executed in the M3 memory. This step needs 24 + 24 + 24 = 72 read/write cycles in the M3 memory. Total 32 + 32 + 40 + 28 + 6 + 72 = 210 cycles are needed for processing the CIRC correction code.

## Claims

1. An apparatus for Cross Interleave Reed-Solomon Code or CIRC decoding of data, the apparatus having a first and a second syndrome generator (6, 7) for calculating a C1 respectively C2 syndrome, a first and a second input formatter (11, 12) connected to an output of the first respectively second syndrome generator (6, 7) for converting the C1 respectively C2 syndrome into first respectively second input data, and a first and second correction block (17, 18) for correcting erroneous bytes of C1 respectively C2 codewords, the apparatus **characterised by** having a single Reed-Solomon Decoder (14), a multiplexer (13) for selecting one of the first and the second input data as input for the Reed-Solomon Decoder (14), and a demultiplexer (15) for distributing an output of the Reed-Solomon Decoder (14) to either the first or the second correction block (17, 18).

2. The apparatus of claim 1, where the Reed-Solomon Decoder (14) comprises a KeySolver subunit (19) and a ChienSolver subunit (20), and where both subunits are independently equipped to wait for a request from a demander, to start their respective operation upon such request, to possibly request some activity from a subsequent module, and to return to the idle state after their respective operation is finished.

3. A method for error correction decoding data that have been Cross Interleave Reed-Solomon Coded, where first and second syndrome sets (C1, C2) are generated in a first and second syndrome generator (6, 7), respectively, where a first and second RS decoding request (D1, D2) are generated after the first and second syndrome set (C1, C2) has been calculated, respectively; the method **characterised in that** a first and a second RS decoding process (E, F) are together performed in a single RS Decoder (14) consisting of one KeySolver (19) for performing a first part of the RS decoding process (E, F) and one ChienSolver (20) for performing a second part of the RS decoding process (E, F); and **in that** the second RS decoding process (F) is started in the KeySolver (19) after the KeySolver (19) has finished the first part of the first RS decoding process (E) and before the ChienSolver (20) has finished the second part of the first RS decoding process (E).

4. The method of claim 3, where a first erroneous byte correction (H) is started after the first RS decoding process (E) has been finished and before the second RS decoding process (F) has been finished.
